# DEMANDE DE BREVET EUROPEEN

(11) **EP 1 256 982 A1**
(43) Date de publication de la demande: **13.11.2002**
(21) Numéro de dépôt: 01810461.2
(22) Date de dépôt: 11.05.2001
(51) Int. Cl.: H01L 23/498, H01L 23/538

(54) **Module électronique et son procede d'assemblage**

(71) Demandeur: Valtronic S.A., 1343 Les Charbonnières (CH)
(72) Inventeur: Ferrando, Frédéric, 1347 Le Sentier (CH); Clot, Philippe, 1343 Les Charbonnières (CH); Racault, Jean-Paul, 25370 Saint-Antoine (FR)
(74) Mandataire: Gresset, Jean

(57) **Abrégé**

Le module électronique selon l'invention est du type comportant:
- un circuit imprimé (10) comprenant un substrat souple ou semi-rigide (12) doté d'un réseau de pistes conductrices (14) déposées sur chacune de ses faces et d'une pluralité de plages de contact (16) déposées sur sa face supérieure et reliées à son réseau de pistes conductrices,
- au moins une puce électronique (18) dotée, sur sa face active, de protubérances conductrices (20) respectivement appliquées sur les plages de contact, et
- une couche de colle non conductrice (22) réunissant le substrat et la puce.

Afin d'éviter la déformation du module lors de la fixation de la puce par application de température et de pression, le substrat (12) est doté, sur sa face inférieure, d'une pluralité de plages de renforcement (24) disposées chacune en regard d'une des plages de contact (16).

## Description

La présente invention se rapporte aux techniques d'assemblage des circuits intégrés, aussi communément désignés puces électroniques. Elle concerne, plus particulièrement, un module électronique constitué d'un support d'interconnexion ou substrat et d'au moins une puce fixée sur celui-ci. L'invention concerne également un procédé d'assemblage d'un tel module.

La miniaturisation, de plus en plus poussée, des puces électroniques ne peut se faire sans une adaptation, en parallèle, des techniques de montage de ces composants sur leur support d'interconnexion.

Un procédé, maintenant reconnu comme très bien adapté aux exigences mentionnées ci-dessus, est le procédé dit "Flip-Chip" selon lequel les puces, retournées, sont fixées, par l'intermédiaire de protubérances conductrices, plus communément appelées "bumps", sur les plages de contact, plus communément appelées "pads", du support d'interconnexion.

La solution est séduisante dans son principe mais délicate dans sa mise en oeuvre. Il est nécessaire, en effet, de veiller à ce que la connexion électrique des "bumps" sur les "pads" soit optimale et que la puce soit solidement fixée sur son substrat.

La présente invention a pour but de fournir un module électronique dont la structure et le procédé d'assemblage répondent parfaitement à de telles exigences.

De façon plus précise, l'invention concerne un module électronique du type comportant:
- un circuit imprimé comprenant un substrat souple ou semi-rigide doté d'un réseau de pistes conductrices déposées sur chacune de ses faces et d'une pluralité de plages de contact déposées sur sa face supérieure et reliées à son réseau de pistes conductrices,
- au moins une puce électronique dotée, sur sa face active, de protubérances conductrices respectivement appliquées sur lesdites plages de contact, et
- une couche de colle non conductrice réunissant ledit substrat et ladite puce.

Selon l'invention, le substrat d'un module tel que défini ci-dessus est doté, sur sa face inférieure, d'une pluralité de plages de renforcement disposées chacune en regard d'une desdites plages de contact.

Dans une variante de réalisation avantageuse, le circuit imprimé comprend, sous son substrat, au moins un deuxième substrat souple ou semi-rigide doté d'un réseau de pistes conductrices déposées sur au moins une de ses faces, et une couche de colle non conductrice réunissant les deux substrats. Dans ce cas, le deuxième substrat est doté, sur sa face inférieure, d'une pluralité de plages de renforcement disposées chacune en regard d'une des plages de contact.

Dans une autre variante de réalisation avantageuse, le circuit imprimé comprend, sous le substrat souple ou semi-rigide, un substrat rigide et une couche de colle non conductrice réunissant ces deux substrats.

De préférence, les plages de renforcement sont en cuivre et ont sensiblement la même épaisseur que les pistes conductrices. Certaines de ces plages peuvent être avantageusement constituées par des portions des pistes conductrices elles-mêmes.

La présente invention concerne également un procédé de réalisation du module défini ci-dessus, du type consistant à déposer la couche de colle non conductrice sur la partie du circuit imprimé qui doit recevoir la puce, à disposer la puce sur le circuit de manière à ce que ses protubérances conductrices viennent en regard des plages de contact concernées, puis à réaliser leur interconnexion en élevant la température de l'ensemble et en exerçant sur la puce une pression suffisante pour que les protubérances traversent la couche de colle et soient écrasés contre les plages de contact sans qu'il subsiste de colle entre eux.

Selon l'invention, la température de l'ensemble est:
- pendant un premier intervalle de temps, maintenue constante à un premier niveau permettant de réduire suffisamment sa viscosité pour qu'elle se répartisse au mieux par capillarité dans l'espace entre la puce et le circuit imprimé,
- pendant un deuxième intervalle de temps, élevée à un deuxième niveau permettant l'accélération de sa polymérisation,
- maintenue à ce deuxième niveau pendant un troisième intervalle de temps, puis
- pendant un quatrième intervalle de temps, redescendue à un troisième niveau.

De façon avantageuse, lesdits premier, deuxième et troisième niveaux de température sont respectivement d'environ 180 °C, 220 °C et 200 °C, tandis que lesdits premier, deuxième, troisième et quatrième intervalles de temps sont respectivement d'environ 5, 2, 5 et 3 secondes.

D'autres caractéristiques et avantages de l'invention ressortiront de la description qui va suivre, faite en regard du dessin annexé, sur lequel:
- la figure 1 représente un module utilisant un circuit imprimé souple mono-couche, en 1a selon l'invention et en 1b selon l'art antérieur;
- la figure 2 est un diagramme servant à illustrer le procédé d'assemblage du module;
- la figure 3 représente un module utilisant un circuit imprimé souple multi-couche; et
- la figure 4 représente un module utilisant un circuit imprimé rigide.

On précisera que, sur le dessin, les éléments communs aux différents modes de mise en oeuvre de l'invention sont désignés par les mêmes numéros de référence.

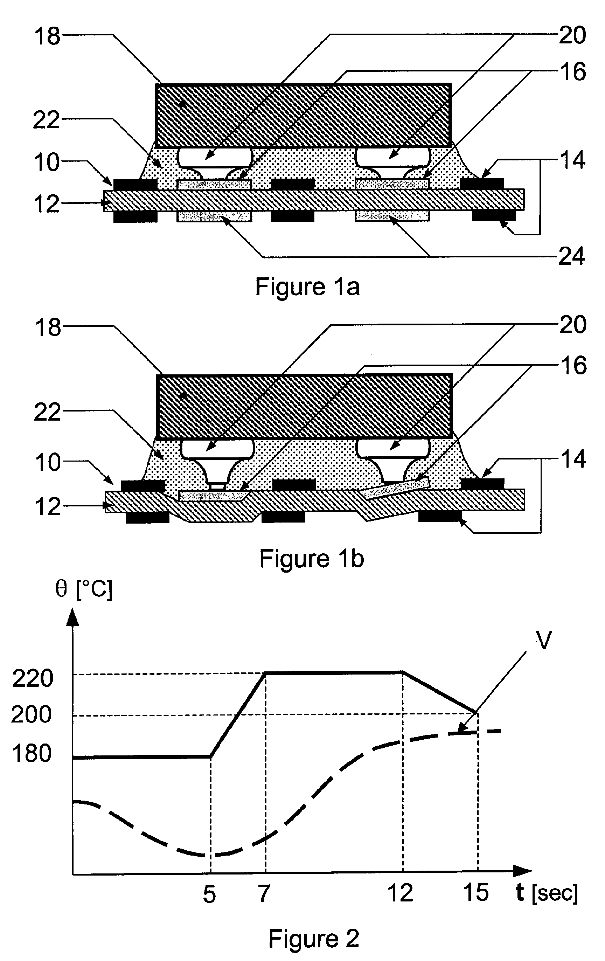

Le module de la figure 1a possède un circuit imprimé souple mono-couche 10 constitué, de manière classique, par un substrat 12 en polyimide présentant une épaisseur de 25 ou 50 µm, par exemple et par deux réseaux de pistes conductrices 14 en cuivre ayant, typiquement, une épaisseur de l'ordre de 10 µm, déposés sur chacune des faces du substrat.

Sur la face supérieure du substrat 12, les pistes conductrices communiquent avec une pluralité de plages de contact ou "pads" 16, de forme sensiblement rectangulaire, dont deux seulement apparaissent sur la figure, destinés à la connexion de composants électroniques divers. De manière classique, ces "pads" ont une structure formée, en partant du substrat, d'une couche de cuivre, d'environ 20 µm d'épaisseur après remétallisation, d'une couche de nickel, d'environ 2 à 3 µm d'épaisseur et d'un flash d'or.

La figure montre un circuit intégré ou puce 18 qui est déposé en mode "Flip Chip" sur deux des "pads" 16 de la face supérieure du substrat 12 par l'intermédiaire de protubérances conductrices ou "bumps" 20 ménagées sur sa face active, en forme de champignon, avantageusement en or, et bien connues de l'homme de métier.

La fixation des protubérances 20 sur les plages 16 se fait directement et n'implique ni soudage ni collage. Elle est simplement assurée, ainsi qu'il sera précisé plus loin, grâce à la présence d'une couche de colle en principe non conductrice 22 préalablement déposée sur le substrat, selon des techniques connues, qui remplit l'espace entre la puce 18 et le circuit imprimé 10, les rendant ainsi solidaires et enrobant en même temps les "bumps" 20 et les pads "16". On notera ici que le durcissement de la colle 22 par polymérisation s'accompagne d'une diminution de son volume, ce qui a pour effet d'attirer plus fortement encore les "bumps" contre les "pads".

Afin de réaliser la mise en place de la puce 18 de manière à garantir une bonne connexion électrique entre "bumps" 20 et "pads" 16, il est nécessaire d'exercer sur la puce une pression suffisamment forte pour écraser les "bumps" contre les "pads". On comprendra aisément, en regardant la figure 1b, que cette action peut provoquer une déformation du substrat 12 et, de ce fait, un écrasement irrégulier des "bumps" 20, avec interposition de colle. Il en résulte une mauvaise connexion électrique entre "bumps" et "pads".

Pour éliminer ce risque et garantir donc la régularité de l'écrasement des protubérances 20, le module selon l'invention est doté, sur la face inférieure du substrat 12, comme le montre la figure 1a, de plages de renforcement ou "contre-pads" 24, disposées chacune en regard d'une plage 16. Ces "contre-pads" 24 ont sensiblement la même forme rectangulaire que les pads 16. Ils ont la même épaisseur que les pistes conductrices 14 et sont, comme elles, réalisés en cuivre.

En variante, et de manière avantageuse, certaines des plages de renforcement 24 peuvent être constituées par des portions des pistes conductrices 14 elles-mêmes dont le trajet est adapté de manière à les faire passer juste en-dessous des plages 16.

La couche de colle non conductrice 22 utilisée pour l'assemblage du module est préalablement déposée sur la partie du circuit imprimé 10 qui doit recevoir la puce 18. Celle-ci est alors placée sur le circuit imprimé de manière à ce que ses "bumps" 20 viennent en regard des "pads" 16 concernés. Comme déjà mentionné, l'interconnexion est effectuée en élevant la température de l'ensemble et en exerçant sur la puce 18 une pression suffisante pour que les "bumps" 20 traversent la couche de colle et soient écrasés contre les "pads" 16.

La couche de colle 22 joue donc un rôle déterminant pour assurer, non seulement, un contact électrique optimum entre protubérances 20 et plages 16, mais aussi, une bonne fixation de la puce 18 sur le circuit imprimé 10.

Il est nécessaire, en effet, lors de l'opération d'écrasement des "bumps" 20, que la colle non conductrice 22 se répartisse au mieux dans tout l'espace, sans laisser subsister de bulles d'air nuisibles à la bonne tenue de l'assemblage et sans s'interposer entre "bumps" et "pads". La viscosité de la colle doit donc, à ce moment, être très faible.

Il est nécessaire, ensuite, de procéder à un durcissement de la colle 22 par polymérisation qui, pour d'évidentes raisons économiques, doit se faire aussi rapidement que possible.

On se référera maintenant à la figure 2 qui illustre la meilleure manière de faire varier la température de l'enceinte dans laquelle est placé le module, pour obtenir les effets désirés.

Sur cette figure, la courbe représentant la variation de la température θ en fonction du temps t est en traits pleins, tandis que la courbe représentant la variation de la viscosité résultante V de la colle est en pointillés.

La figure 2 montre que, pendant les 5 premières secondes de l'opération, la température θ est maintenue aux alentours de 180 °C. Ceci a pour effet de réduire de moitié environ la viscosité V de la colle qui passe d'un état pâteux à un état qui lui permet de se répartir au mieux par capillarité dans l'espace entre la puce et le circuit imprimé.

La température passe alors, pendant les 2 secondes suivantes, de 180 vers environ 220 °C, reste à cette valeur pendant 5 secondes puis, pendant les 3 secondes suivantes, redescend vers 200 °C. Ceci permet à la colle de se polymériser très rapidement, mais sans un excès qui serait nocif à sa tenue, pour atteindre l'état solide 15 secondes environ après le début de l'opération. Par comparaison, le durcissement de la colle nécessiterait 35 secondes si la température était maintenue constante à 180 °C, par exemple. Un tel gain de temps est particulièrement avantageux d'un point de vue économique.

Bien entendu, ces températures et ces durées sont données à titre purement indicatif et peuvent varier selon le type de colle utilisé.

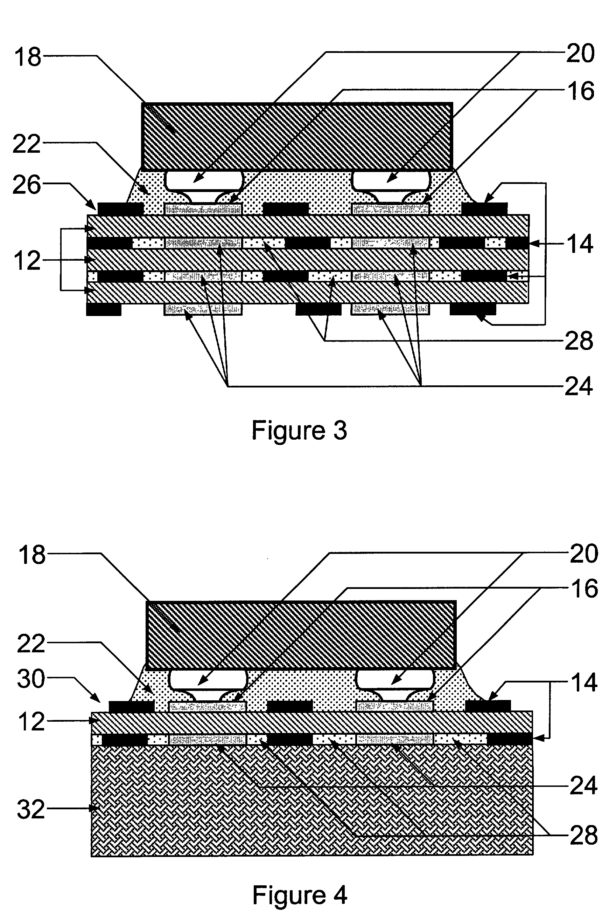

La figure 3 représente un module selon l'invention utilisant un circuit imprimé souple multi-couche 26 constitué, de manière classique, par un empilement de substrats 12, au nombre de trois sur la figure, dotés de réseaux de pistes conductrices 14. L'assemblage de l'empilement est réalisé au moyen de couches de colle 28. Dans ce cas, pour éviter la déformation de la structure au moment de la fixation de la puce 18 par pression et chauffage, comme décrit précédemment, des plages de renforcement 24 sont disposées, en regard de chacun des "pads" 16, non seulement, sur la face arrière du substrat inférieur, mais également, entre les différents substrats.

Enfin, la figure 4 représente un module selon l'invention utilisant un circuit imprimé rigide 30 formé, également de manière classique, d'un substrat souple 12 doté de pistes conductrices 14 et d'un substrat rigide 32, réalisé en résine époxy, sur lequel le substrat 12 est fixé par une couche de colle 28. Dans ce cas, également, pour éviter la déformation du substrat souple 12 au moment de la fixation de la puce 18, des plages de renforcement 24 sont disposées, en regard de chacune des plages 16, sur la face arrière du substrat 12.

## Revendications

1. Module électronique comportant:
- un circuit imprimé (10, 26, 30) comprenant un substrat souple ou semi-rigide (12) doté d'un réseau de pistes conductrices (14) déposées sur chacune de ses faces et d'une pluralité de plages de contact (16) déposées sur sa face supérieure et reliées à son réseau de pistes conductrices,
- au moins une puce électronique (18) dotée, sur sa face active, de protubérances conductrices (20) respectivement appliquées sur lesdites plages de contact, et
- une couche de colle non conductrice (22) réunissant ledit substrat et ladite puce,
**caractérisé en ce que** le substrat (12) est doté, sur sa face inférieure, d'une pluralité de plages de renforcement (24) disposées chacune en regard d'une desdites plages de contact (16).

2. Module selon la revendication 1, **caractérisé en ce que** ledit circuit imprimé (26) comprend, sous ledit substrat (12), au moins un deuxième substrat souple ou semi-rigide (12) doté d'un réseau de pistes conductrices (14) déposées sur au moins une de ses faces, et une couche de colle non conductrice (28) réunissant les deux substrats, et **en ce que** le deuxième substrat est doté, sur sa face inférieure, d'une pluralité de plages de renforcement (24) disposées chacune en regard d'une desdites plages de contact (16).

3. Module selon la revendication 1, **caractérisé en ce que** ledit circuit imprimé (30) comprend, sous le substrat souple ou semi-rigide (12), un substrat rigide (32) et une couche de colle non conductrice (28) réunissant les deux substrats.

4. Module selon l'une des revendications 1 à 3, **caractérisé en ce que** lesdites plages de renforcement (24) sont en cuivre.

5. Module selon la revendication 4, **caractérisé en ce que** lesdites plages de renforcement (24) ont sensiblement la même épaisseur que les pistes conductrices (14).

6. Module selon la revendication 4, **caractérisé en ce que** lesdites plages de renforcement (24) sont constituées par des portions des pistes conductrices (14) elles-mêmes.

7. Procédé de réalisation du module selon la revendication 1, consistant à déposer la couche de colle non conductrice (22) sur la partie du circuit imprimé (10, 26, 30) qui doit recevoir la puce (18), à disposer la puce sur le circuit de manière à ce que ses protubérances (20) viennent en regard des plages (16) concernées, puis à réaliser l'interconnexion en élevant la température de l'ensemble et en exerçant sur la puce une pression suffisante pour que lesdites protubérances traversent la couche de colle (22) et soient écrasés contre les plages (16) sans qu'il subsiste de colle entre eux, **caractérisé en ce que** la température est:
- pendant un premier intervalle de temps, maintenue constante à un premier niveau permettant de réduire suffisamment sa viscosité pour qu'elle se répartisse au mieux par capillarité dans l'espace entre la puce et le circuit imprimé,
- pendant un deuxième intervalle de temps, élevée à un deuxième niveau permettant l'accélération de sa polymérisation,
- maintenue à ce deuxième niveau pendant un troisième intervalle de temps, puis
- pendant un quatrième intervalle de temps, redescendue à un troisième niveau.

8. Procédé selon la revendication 7, **caractérisé en ce que** lesdits premier, deuxième et troisième niveaux de température sont respectivement d'environ 180 °C, 220 °C et 200 °C.

9. Procédé selon la revendication 8, **caractérisé en ce que** lesdits premier, deuxième, troisième et quatrième intervalles de temps sont respectivement d'environ 5, 2, 5 et 3 secondes.
